# EUROPEAN PATENT APPLICATION

(11) **EP 4 106 499 A1**
(43) Date of publication of application: **21.12.2022**
(21) Application number: 21180326.7
(22) Date of filing: 18.06.2021
(51) Int. Cl.: H05K 1/02

(54) **METHOD FOR MANUFACTURING A CARRIER MATERIAL AND A CARRIER MATERIAL WITH DEHEATING PROPERTIES**

(71) Applicant: Rohde & Schwarz GmbH & Co. KG, 81671 München (DE)
(72) Inventor: RIEDMANN, Nico, 81671 München (DE); SAMMER, Roman, 81671 München (DE); ROEHRL, Franz, 81671 München (DE)
(74) Representative: Prinz & Partner mbB

(57) **Abstract**

The present disclosure relates to a method for manufacturing a carrier material for use in an electric and/or thermal component and to a carrier material. The method comprises at least steps of generating at least one first hole in at least a first surface of the carrier material, applying a first material at least partially on the first surface in an area of the at least one first hole such that the first surface is partially covered by means of the first material, applying a second material to fill at least a portion of the at least one first hole, and generating at least one additional second hole in at least the first surface of the carrier material adjacent the first hole such that the at least one second hole at least partially overlaps or directly adjoins the at least one first hole and/or the second material.

## Description

### FIELD OF THE DISCLOSURE

The present disclosure generally relates to a method for manufacturing a carrier material for use in an electric and/or thermal component and to a carrier material.

### BACKGROUND

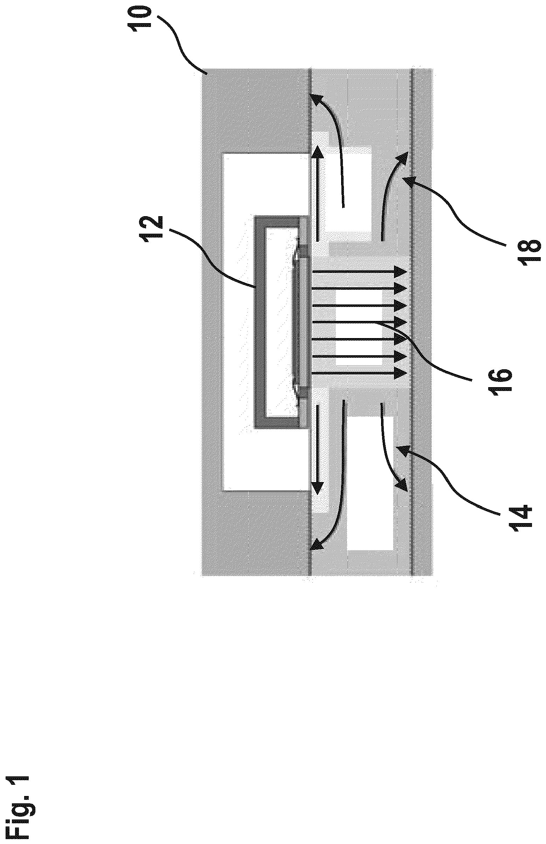

In known thermal and electric components, such as housed high-frequency (HF) amplifiers in quad flat no leads (QFN) packages, efficient and cost-effective heat dissipation (deheating) is problematic. Fig. 1 shows a schematic drawing of a carrier material 10 comprising an electrically conductive portion 12 for transmitting HF signals and the respective heat flows 14, 16, 18 (vertical and horizontal or combined heat flows) which occur in such devices.

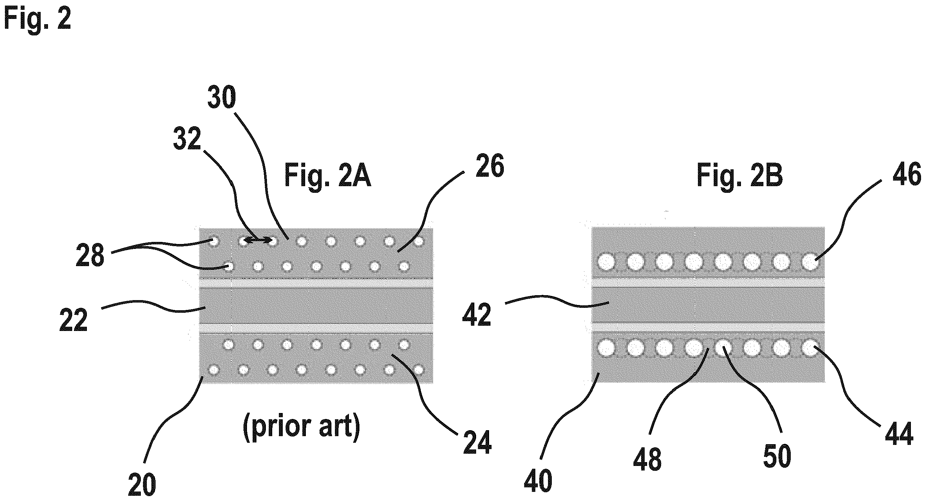

To handle heat dissipation known methods show a tendency from low-cost approaches providing rather poor heat dissipation to expensive approaches providing improved heat dissipation properties. For example, low cost approaches may relate to usage of thinner printed circuit boards (PCBs) which negatively influences the heat dissipation, usage of thicker copper layers which causes limitations on the design rules, and usage of vias which is limited by the manufacturing parameters of the minimum distance between the respective drillings of two neighbored vias and by the minimum dimensions of a rest ring in between those drillings. In this regard, Fig. 2A shows a simplified schematic top view of a via approach of a carrier material 20 according to the prior art. The carrier material 20 comprises an electrically conductive portion 22 and two side portions 24, 26 adjacently arranged on opposite sides of the electrically conductive portion 22. Each of the side portions 24, 26 comprises multiple vias 28 influencing heat dissipation of the carrier material 20 due to the thermal conductivity of the material used for establishing the vias 28, namely the filling material. Between the individual vias 28, rest portions 30 of a base material remain caused by a minimum distance (illustrated by arrow 32) at which two holes for the vias 28 may be drilled. Consequently, the heat dissipating properties are not homogenous due to the alternating sequence of vias 28 and rest portions 30 of the base material of the carrier material 20. Moreover, the heat dissipating properties are not optimized since no continuous portion consisting only of vias 28 which comprise a particular high heat dissipating filling material is provided, namely a material with high thermal conductivity. However, vias with a cost-efficient filling material are up to now the cheapest approach for providing heat dissipation, but this approach is also the one with lowest heat dissipation compared to the more expensive approaches due to the aforementioned aspects.

Intermediate cost approaches include vias which are filled with thermally conductive materials, vias with increased copper wall thickness, and vias which are completely filled with copper which causes worse etch tolerances and worse design rules.

High cost approaches include use of deep milling into the carrier material, for instance the printed circuit board (PCB), to locally reduce the thermal resistance of the PCB which requires additional process steps and also demands suitable layer structures. Further high cost approaches may use pressed-in solid copper in the body of the PCB, e.g. a copper cylinder, also called "copper coin", or the use of glued or soldered solid copper inside the body of the PCB, e.g. stepped copper cylinders, also called "copper inlays".

For the use case of HF amplifiers, the HF characteristics of the carrier material are decisive with regard to the choice of the particular heat dissipation approach. In other words, if in case of a high-frequency circuit a good heat dissipation approach is required, a high cost approach providing better heat dissipation properties than low or mid cost approaches is needed in order not to deteriorate the HF properties. However, in particular the high cost deep milling and copper inlay approaches negatively influence the carrier material yield and, therefore, even further reduce the manufacturing efficiency and cause even higher costs.

Accordingly, there is a need for a heat dissipation technique for thermal and/or electric components which is cost-effective but still provides good heat dissipation properties as well as a high carrier material yield.

### SUMMARY

The subject matter of the independent claims satisfies the respective need. Preferred embodiments are indicated within the dependent claims and the following description, each of which, individually or in combination, may represent aspects of the present disclosure. Some aspects of the present disclosure are explained in view of a method, others in view of a device. However, the aspects are to be correspondingly transferred vice versa.

A summary of certain embodiments disclosed herein is set forth below. It should be understood that these aspects are presented merely to provide a brief summary of these certain embodiments and that these aspects are not intended to limit the scope of this disclosure. This disclosure may encompass a variety of aspects that may not be set forth below.

According to a first aspect, some embodiments relate to a method for manufacturing a carrier material for use in an electric and/or a thermal component. The method comprises at least the step of generating at least one first hole in at least a first surface of the carrier material. The method also comprises the step of applying a first material at least partially on the first surface in an area of the at least one first hole such that the first surface is partially covered by means of the first material. Moreover, the method comprises the step of applying a second material to fill at least a portion of the at least one first hole. The method additionally comprises the step of generating at least one additional second hole in at least the first surface of the carrier material adjacent the first hole such that the at least one second hole at least partially overlaps or directly adjoins the at least one first hole and/or the second material.

In other words, the method relies upon repeated hole formation in at least the first surface of the carrier material. On the one hand, several techniques such as milling could be used to create an enlarged hole in a single milling step. However, generating a single large extended hole would cause a reduced stability of the carrier material. Consequently, the risk of production errors would be high. Since repeated steps of generating the holes are utilized, the holes may be filled with appropriate materials at intermediate production steps, namely in a subsequent manner, such that the stability of the carrier material may be guaranteed during the entire manufacturing process, also when generating additional holes. In other words, several holes may be generated in at least two separate manufacturing steps that are performed in a subsequent manner. The subsequent/repeated steps generating the at least one first hole and the at least one second hole also allow to avoid the limitation of minimum drilling distances that applies to the approaches according to the prior art. Since the at least one first hole is generated in a first step and subsequently filled with material, the at least one second hole may be generated shifted by a distance with respect to the at least one first hole such that the at least one second hole overlaps with or adjoins the at least one first hole or the filling material inside the at least one first hole. In other words, due to the adjoining or overlapping fashion of the (partially filled) holes provided in subsequent steps, it is possible to achieve a protective closed material portion providing improved heat dissipating properties compared to the prior art approaches in a cost-effective manner. This material portion may be beneficial with regard to heat dissipation properties as well as with regard to thermal and/or electric (insulating) properties. Accordingly, good HF properties of the overall carrier material may be achieved using a rather cost-effective via approach. Furthermore, the carrier material yield, e.g. the PCB yield, is not negatively influenced by the respective approach. These advantages may be achieved although cost-intensive approaches such as copper-inlays or pressed-in copper are avoided.

The holes may extend from a first surface of the carrier material to an opposite second surface of the carrier material and, thus, may be considered through holes. However, this is optional. The holes may also only extend a certain depth from the first surface of the carrier material towards the second surface being opposite and, thus, could also be considered recesses. Thus, the second surface may be closed or rather comprise a continuous or rather undisturbed finish. A certain device may be connected by penetrating the second surface in order to get in contact with the material filled.

The holes may be generated by means of any suitable generating technique, such as drilling, milling, etching, lasering or the like. Accordingly, the holes may also be considered a punctuation, cavity or drilling.

Generally, the holes may comprise a circular cross-sectional shape in a top view. However, other cross-sectional shapes are conceivable as well, such as e.g. rectangular cross-sectional shapes. The holes may also comprise a substantially cylindrical volume. The volume may be defined by the walls of the hole as well as the considered top surface being flush with the first surface of the carrier material adjacent the hole and a bottom surface. The bottom surface of the hole may either be the lower hole end (if the hole is no through hole but ends at a certain depth from the first surface of the carrier material) or a bottom surface being flush with the second surface of the carrier material adjacent the hole. The holes may also comprise a first diameter at the height of the first surface of the carrier material adjacent to the holes. Then, the holes may comprise a second diameter at a depth from the first surface of the carrier material adjacent to the holes, wherein the second diameter may be smaller than the first diameter. Thus, the holes may also comprise a truncated cone shaped volume.

The carrier material may comprise a printed circuit board (PCB). The carrier material may also be configured for HF applications. In particular, the carrier material may comprise a HF conductor for conducting HF signals. In fact, the carrier material may comprise an electrically conductive portion which may be configured for transmitting HF signals.

Throughout the present disclosure HF signals (high frequency or rather radio frequency signals) may have a frequency within the range of 1 MHz to 100 GHz. High frequency applications are used in manifold applications nowadays.

The application of the first material at least partially on the first surface in an area of the at least one first hole may also be considered a plating. Accordingly, the step of applying the first material may also be considered galvanizing the at least one first hole.

Generally, the first surface (at least partly), edges and/or inner walls of the at least one first hole may be covered by the first material when applying the first material on the first surface in the respective area in which the at least one first hole was generated. The inner walls of the at least one first hole correspond to the limitation of the at least one first hole, wherein the inner walls are made by the base material of the carrier material.

The application of the second material to at least partially fill the at least one first hole may also be considered plugging.

Optionally, the method may comprise the step of applying a photoresist prior to the application of the first material. The photoresist may provide the possibility that only a specified portion of the first surface of the carrier material and/or of the at least one first hole is applied with the first material, namely its edge(s) and/or inner walls. Accordingly, application of the first material and/or the second material on at least some portions of the carrier material adjacent the at least one first hole may be avoided. For example, the photoresist may also prevent the application of the first material on any other portion of the carrier material other than the area associated with the at least one first hole.

Furthermore, the method may comprise at least the additional step of applying a third material at least partially on the first surface in an area of the at least one second hole such that the first surface is partially covered by means of the third material. In other words, subsequent to generating the at least one second hole, this hole may also be platted.

If a photoresist was applied prior to the application of the first material, this photoresist may optionally be removed prior to generating the at least one second hole.

The area of the at least one first hole may correspond to the area of the at least one second hole since the respective holes may be made such that they partly overlap or directly adjoin each other.

In addition, the method may comprise at least the additional step of applying a fourth material to fill at least a portion of the at least one second hole. Similar as in case of the at least one first hole, the at least one second hole may be filled, i.e. plugged. The creation of the at least one second hole and the subsequent filling of the at least one second hole provides the possibility to increase the amount of filling material inside a body portion of the carrier material by 100% compared to the configuration that only the first hole is filled. Therefore, the deheating properties may be improved compared to the case of only first hole(s). Moreover, due to the overlapping or adjoining of the at least one first hole and the at least one second hole, the filling of the second hole, e.g. the fourth material, may be in direct contact with the filling of the first hole, e.g. the second material. Accordingly, a closed continuous material portion may be established consisting of the second material and the fourth material. This means that the deheating properties are also improved in that they are established more localized. Also, the thermal and/or electric (insulating) properties established by the second material and the fourth material are more concentrated. As a consequence, the HF properties of the carrier material may be improved.

Optionally, a photoresist may also be applied prior to the application of the third material. The photoresist may provide the possibility that only the area associated with the at least one second hole on the first surface is applied with the third material. Accordingly, application of the third material and/or the fourth material on remaining portions of the carrier material adjacent the at least one second hole may be avoided.

The fourth material may comprise a high thermally conductive material. For example, the fourth material may comprise copper or a copper based alloy. Accordingly, the heat dissipating properties may be further improved.

The fourth material may have a thermal expansion coefficient substantially similar to a thermal expansion coefficient of a printed circuit board. If the thermal expansion coefficients are similar to each other, cracking of the fourth material due to repeated temperature variations may be avoided. Thus, the life time of the filling material may be improved, particularly the one of the carrier material at all.

The fourth material may also comprise a high galvanic conductive material. For example, the fourth material may comprise a Ag-Cu alloy. Then, active atoms of the material may capture electrons of inactive atoms and generate metallic ions in the material. As a consequence, the ions may establish at least partially a conductive path inside nominally insulating portions of the carrier material when applying a bias voltage.

The fourth material may further comprise a high heat dissipation material. Then, the heat dissipating properties are further improved.

The first material and the third material may be same.

Further, the second material and the fourth material may be same. In this case, the closed continuous material portion established via the filling materials of the at least one first hole and the at least one second hole may be established by a single material. Hence, the heat dissipating and/or thermal and/or electric properties may be more homogenous.

The method may also be extended in that a plurality of first holes and a plurality of second holes are generated such that each of the second holes at least partially overlaps with or adjoins at least one of the first holes and/or the second material. Then, an extended continuous material portion consisting of the second and fourth material may be established. Thus, extended deheating sections, optionally comprising thermal and/or electric (insulating) properties may be achieved. This may assist in further improving the HF properties for HF devices, such as HF conductors.

For instance, the several first holes are provided in a single manufacturing step. Further, the several second holes may also be provided in a single manufacturing step that is done subsequently.

Generally, the several first holes or rather the several second holes may be arranged in line(s).

Particularly, neighbored holes of the several first holes may be distanced by a distance that corresponds to the dimension of the second holes, particularly their respective diameter.

Moreover, neighbored holes of the several second holes may be distanced by a distance that corresponds to the dimension of the first holes, particularly their respective diameter.

Optionally, the second material may comprise a high thermally conductive material. For example, the second material may comprise copper or a copper based alloy.

The second material may also have a thermal expansion coefficient (substantially) similar to a thermal expansion coefficient of a printed circuit board, namely a PCB.

The second material may comprise a high galvanic conductivity material.

The second material may also comprise a high heat dissipation material.

The advantages and effects mentioned with regard to the fourth material and the particular properties may be similarly achieved in view of the second material.

Optionally, the carrier material may comprise at least one inlaid portion of pressed-in copper embedded within the carrier material. This may assist in further improving the heat dissipating properties.

Also, the carrier material may comprise at least one inlaid portion of bonded or soldered copper embedded within the carrier material. This is another measure to further improve the heat dissipating properties.

As an additional option, multiple side portions comprising multiple first holes and multiple second holes which at least partially overlap or adjoin each other at least in view of filling materials may be established by repeated steps. Accordingly, the amount of the second and/or fourth material may be further increased. In effect, multiple sections inside the carrier material of continuous filling material may be generated. Consequently, the heat dissipating properties may be further improved according to the respective needs.

According to another aspect, some embodiments relate to a carrier material for use in an electric and/or thermal component. The carrier material comprises an electrically conductive portion. The carrier material also comprises at least a first side portion adjacently arranged to the electrically conductive portion on a first side of the carrier material. Multiple vias are provided in the first side portion. Each of the multiple vias comprises at least a first material. Each of the multiple vias at least partially overlaps or directly adjoins another of the multiple vias.

The first material may be considered a filling material.

The carrier material may comprise a PCB.

Consequently, a carrier material is provided which comprises a beneficial single continuous side portion consisting of overlapping or adjoining vias comprising the first material. Due to the continuity, the heat dissipating and/or thermally and/or electrically (insulating) properties may be improved compared to carrier materials which do not comprise continuous via portions. Hence, the carrier material as a whole in view of the electrically conductive portion may show improved conducting properties.

In particular, the electrically conductive portion may be configured for transmitting HF signals. Then, a side portion as specified before may be advantageous to achieve good HF conducting properties.

In fact, the first side portion may be arranged in parallel with the electrically conductive portion. In other words, there may be a constant distance between the electrically conductive portion and the at least one side portion.

Each of the vias may at least partially comprise a second material, wherein the second material is arranged between the first material and a body portion of the carrier material. The second material may be considered a plating material. The second material may be used to galvanize the holes from which the vias are formed. Then, the life time of the first material which may be laterally surrounded by the second material may be improved.

The first material may comprise a high thermally conductive material.

The first material may also have a thermal expansion coefficient substantially similar to a thermal expansion coefficient of a PCB.

Furthermore, the first material may comprise a high galvanic conductivity material.

Additionally, the first material may comprise a high heat dissipation material.

With regard to the method described hereinbefore the second material may be considered to filling material. In view of the carrier material, the first material may be considered the filling material. The effects and advantages are to be correspondingly transferred.

The carrier material may comprise at least one inlaid portion of pressed-in copper embedded within the carrier material.

Also, the carrier material may comprise at least one inlaid portion of bonded or soldered copper embedded within the carrier material.

### DESCRIPTION OF THE DRAWINGS

The forgoing aspects and further advantages of the claimed subject matter will become more readily appreciated as the same become better understood by reference to the following detailed description when taken in conjunction with the accompanying drawings. In the drawings,
- Fig. 1 is a schematic drawing of a carrier material illustrating heat flows,
- Figs. 2A and 2B are schematic drawings of a carrier material comprising an electrically conductive portion and heat dissipating portions according to the prior art and the present disclosure, respectively,
- Fig. 3 is a schematic drawing that illustrates the steps of a method for manufacturing a carrier material according to another embodiment,
- Fig. 4 is a series of schematic drawings that illustrate the steps of a method for manufacturing a carrier material according to an embodiment, and
- Fig. 5 is a series of schematic drawings that illustrate the steps of a method for manufacturing a carrier material according to another embodiment.

### DETAILED DESCRIPTION

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed. Various modifications to the described embodiments will be readily apparent to those skilled in the art, and the general principles defined herein may be applied to other embodiments and applications without departing from the spirit and scope of the described embodiments. Thus, the described embodiments are not limited to the embodiments shown, but are to be accorded the widest scope consistent with the principles and features disclosed herein.

All of the features disclosed hereinafter with respect to the example embodiments and/or the accompanying figures can alone or in any subcombination be combined with features of the aspects of the present disclosure including features of preferred embodiments thereof, provided the resulting feature combination is reasonable to a person skilled in the art.

For the purposes of the present disclosure, the phrase "at least one of A, B, and C", for example, means (A), (B), (C), (A and B), (A and C), (B and C), or (A, B, and C), including all further possible permutations when greater than three elements are listed. In other words, the term "at least one of A and B" generally means "A and/or B", namely "A" alone, "B" alone or "A and B".

Figs. 2B is a schematic drawing of a carrier material 40 comprising an electrically conductive portion 42 and heat dissipating portions according to the present disclosure.

The carrier material 40 comprises the electrically conductive portion 42 for transmitting HF signals. The carrier material 40 also comprises a first side portion 44 and a second side portion 46. The first side portion 44 and the second side portion 46 are adjacently arranged on opposite sides of the electrically conductive portion 42. The side portions 44, 46 may be coupled to ground or another suitable reference potential such that transmitting the HF signals is not deteriorated. Although two side portions 44, 46 are shown here, the carrier material 40 may also comprise only a single side portion depending on the respective needs.

As an example, the first side portion 44 comprises multiple first holes 48 and multiple second holes 50. The first holes 48 are already filled with an appropriate filling material and, thus, are considered vias. After the first holes 48 have been filled with the respective filling material, the second holes 50 are generated at center positions shifted relative to the center positions of the first holes 48.

The shifting and the diameters of the respective holes 48, 50 are chosen such that the second holes 50 overlap with the filling material of the first holes 48 as shown in Figure 2B. In principle, a direct adjoining configuration may also be sufficient according to which the respective holes 48, 50 directly adjoin each other in an alternating manner. Moreover, although multiple first and second holes 48, 50 are depicted, single holes of each type may also be sufficient according to the respective needs.

Optionally, the carrier material 40 may comprise a printed circuit board, abbreviated by PCB.

Accordingly, the holes 48, 50 are provided on a first surface of the carrier material 40, particularly in a (same) area.

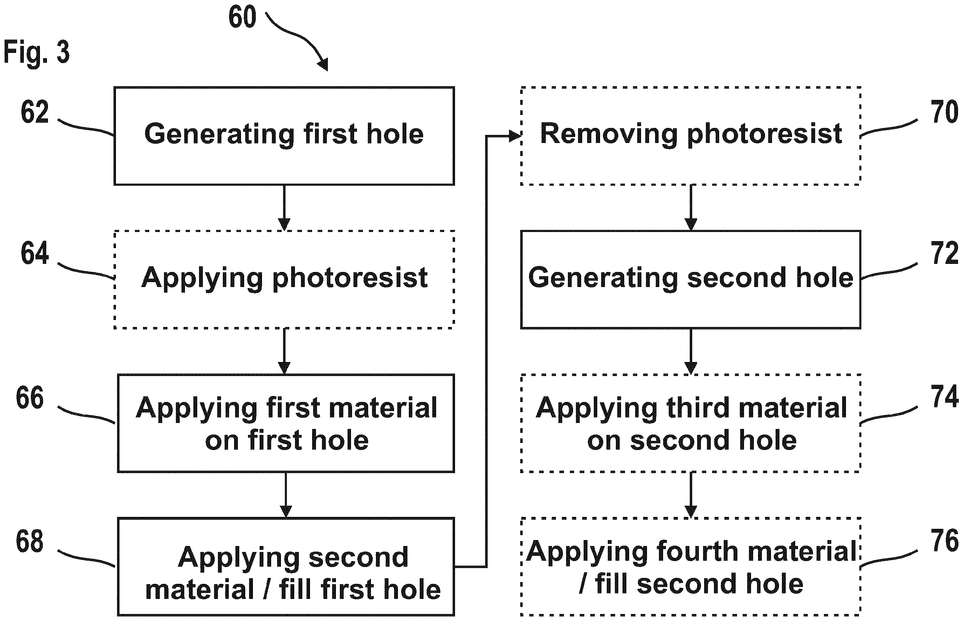

Fig. 3 is a schematic drawing illustrating the respective steps of a method 60 for manufacturing a carrier material according to an embodiment.

In step 62, at least one first hole is generated in the first surface of the carrier material, e.g. by means of drilling, milling, etching, or lasering.

In optional step 64, a photoresist is applied on the first surface of the carrier material. The photoresist may be applied such that only the holes are uncovered or that at least a portion of the first surface of the carrier material is prevented from the application of additional material, e.g. the portion including the area of the first holes and/or second holes.

In step 66, a first material may be applied on the first surface in the area of the at least one first hole, namely the area that comprises the at least one first hole. Depending on whether a photoresist was applied before, a remainder of the carrier material adjacent the at least one first hole may also be applied with the first material. The first material may have electrically and/or thermally (insulating) and/or heat dissipating properties. This step may also be referred to as galvanizing the at least one first hole.

In step 68, a second material is at least partially applied into the at least one first hole such that the hole is at least partially filled by the second material. This step may also be referred to as plating of the at least one first hole. Filling of the at least one first hole may establish a via inside the carrier material extending from the first surface at least up to a certain depth. Optionally, the via may extend through the entire carrier material from a first side to an opposite second side.

In optional step 70, the photoresist as well as first and second material portions partially applied on the photoresist above carrier material portions adjacent to the at least one first hole may be removed. In this regard, etching may be used. The photoresist may thus assist in preparing a smooth first surface of the carrier material and the at least one filled first hole.

In step 72, at least one second hole is generated in the first surface of the carrier material. The at least one second hole is generated so shifted relative to the at least one first hole that the second hole overlaps or at least directly adjoins with the second material of the at least one first hole. Accordingly, a continuous portion inside the carrier material is achieved which may serve for providing heat dissipating properties.

In optional step 74, a third material may be applied to the first surface of the at least one second hole. Accordingly, the at least one second hole may be galvanized by means of the third material.

In optional step 76, a fourth material may be applied to the at least one second hole such that the second hole is at least partially filled. This may be considered plating or plugging the at least one second hole. Then, a continuous portion inside the carrier material may be established comprising only the second and the fourth materials. Optionally, the second and the fourth material may be same and particularly suited for providing good heat dissipating properties.

The first material and the third material may be same.

In fact, the second and/or the fourth material may comprise high thermally conductive materials and/or high heat dissipating materials and/or high galvanic conductivity materials and/or may have a thermal expansion coefficient substantially similar to a thermal expansion coefficient of a PCB.

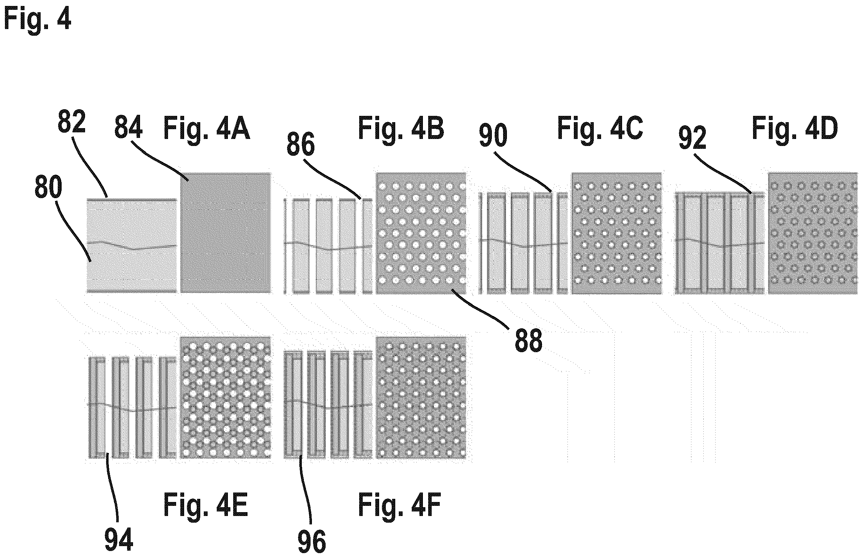

Fig. 4 is a series of schematic drawings that illustrate the respective steps of a method for manufacturing a carrier material according to an embodiment. Each of the subfigures shows a schematic cross-sectional view 82 through the carrier material 80 and a top view 84 on the carrier material 80.

Fig. 4A shows the carrier material 80 prior to any treatment, for instance a printed circuit board.

In Fig. 4B multiple first holes 86 are generated, e.g. by means of drilling, within the first surface 88 of the carrier material 80. In Fig. 4C a first material 90 is applied to the first surface 88 of the carrier material 80 in an area of the first holes 86, namely an area comprising the first holes 86, in order to galvanize the first surface 88 of the first holes 86.

In Fig. 4D a second material 92 is applied to at least partially fill the first holes 86 in order to plate the first holes 86 such that vias are achieved.

In Fig. 4E multiple second holes 94 are generated in the first surface 88 of the carrier material 80, e.g. by drilling. The second holes 94 are shifted relative to the filled first holes 86 such that the second holes 94 at least partially overlap or directly adjoin the vias generated from the first holes 86. Put differently, the second holes 94 are positioned with respect to the first holes 86 such that the second holes 94 overlap or directly adjoin the first holes 86 or rather the second material 92 filled into the first holes 86 at least partly in a previous step.

In Fig. 4F, according to an optional step, a third material is at least partially applied to the first surface 88 of the carrier material 80, particularly in an area of the second holes 94 in order to galvanize the second holes 94.

Although the first holes 86 and the second holes 94 are depicted to extend from the first surface 88 of the carrier material 80 through the entire body, this is optional. The holes 86, 94 may also extend only a certain depth from the first surface 88 of the carrier material 80 towards the second surface being opposite with respect to the first surface 88. In this case, the holes 86, 94 may rather be considered recesses.

Moreover, the holes 86, 94 are depicted as comprising a constant width along the direction from the first surface 88 to the second surface as shown in the cross-sectional view 82. However, the holes 86, 94 may also have different shapes, such as representing a truncated cone, namely reducing their width (constantly).

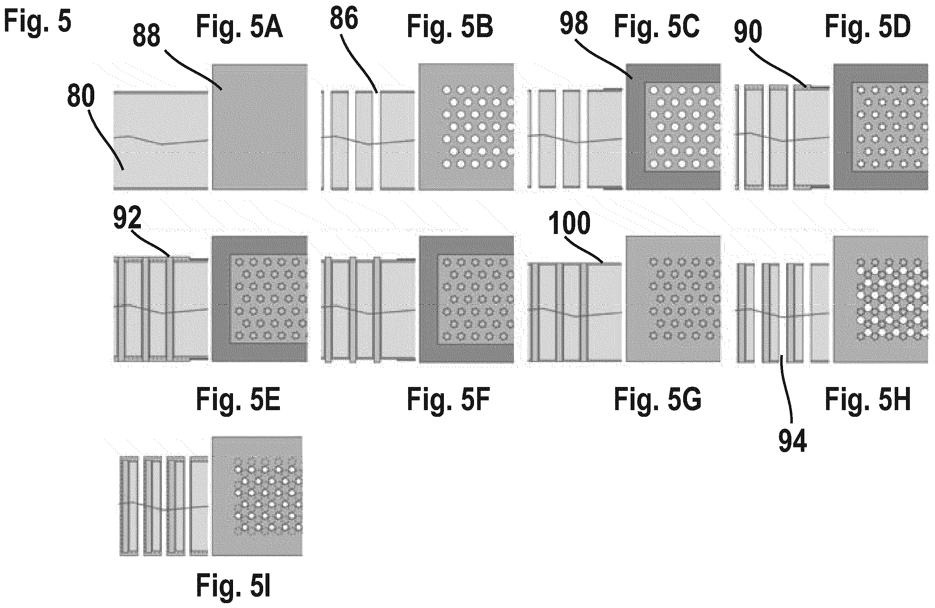

Fig. 5 is a series of schematic drawings that illustrate respective steps of a method for manufacturing a carrier material 80 according to another embodiment. This embodiment deviates from the embodiment of Fig. 4 only in certain aspects. Therefore, only the differences are explained in detail herein below.

Figs. 5A and 5B correspond to Figs. 4A and 4B of the before described embodiment.

In Fig. 5C a photoresist 98 is applied at least partially on the first surface 88 of the carrier material 80, particularly in an area that does not comprise the first holes 86 as shown in Figure 5C, namely the top view on the carrier material 80.

In Fig. 5D a first material 90 is at least partially applied on the first surface 88 of the carrier material 80, namely in the area of the first holes 86.

The photoresist 98 prevents certain portions of the carrier material 80 to be covered by the first material 90, namely the area that does not comprise the first holes 86. In other words, the photoresist 98 is a measure to apply the first material 90 only at specific portions of the carrier material 80 such as the area having the first holes 86.

In Fig. 5E the first holes 86 are filled by means if the second material 92.

In Fig. 5F, the second material 92 is locally removed, e.g. through etching. In fact, the second material 92 is removed in the area of first holes 86, particularly a sub-area between neighbored first holes 86.

In Fig. 5G the photoresist 98 and remaining portions of the second material 92 protruding from the first surface 88 of the carrier material 80 are removed. Accordingly, a smooth surface 100 is established on the carrier material 80.

In Fig. 5H, multiple second holes 94 are generated in the first surface 88 of the carrier material 80, which has been smoothed previously. The second holes 94 are displaced relative to the first holes 86 as described before such that the second holes 94 partially overlap or directly adjoin the first holes 86 and/or the second material filled in before.

In Fig. 5I the second holes 94 are galvanized through the application of a third material on the first surface 88, particularly in the area on the first surface 88, which comprises the second holes 94 (and the first holes 86). However, the entire first surface 88 may be galvanized in the end.

Generally, the carrier material 80 may comprise at least one inlaid portion of pressed-in copper embedded within the carrier material. The carrier material 80 may also comprise at least one inlaid portion of bonded or soldered copper embedded within the carrier material.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

Although the disclosure has been illustrated and described with respect to one or more implementations, equivalent alterations and modifications will occur to others skilled in the art upon the reading and understanding of this specification and the annexed drawings. In addition, while a particular feature of the disclosure may have been disclosed with respect to only one of several implementations, such feature may be combined with one or more other features of the other implementations as may be desired and advantageous for any given or particular application.

## Claims

1. A method for manufacturing a carrier material for use in an electric and/or thermal component, the method comprising at least the following steps:
- Generating at least one first hole in at least a first surface of the carrier material,
- Applying a first material at least partially on the first surface in an area of the at least one first hole such that the first surface is partially covered by means of the first material,
- Applying a second material to fill at least a portion of the at least one first hole, and
- Generating at least one additional second hole in at least the first surface of the carrier material adjacent the first hole such that the at least one second hole at least partially overlaps or directly adjoins the at least one first hole and/or the second material.

2. The method according to claim 1, wherein the method comprises at least the additional steps of:
- Applying a third material at least partially on the first surface in an area of the at least one second hole such that the first surface is partially covered by means of the third material, and
- Applying a fourth material to fill at least a portion of the at least one second hole.

3. The method according to claim 2, wherein the fourth material comprises a high thermally conductive material, and/or
wherein the fourth material has a thermal expansion coefficient substantially similar to a thermal expansion coefficient of a printed circuit board,
wherein the fourth material comprises a high galvanic conductivity material, and/or
wherein the fourth material comprises a high heat dissipation material.

4. The method according to claim 2 or 3, wherein the first material and the third material are same and/or wherein the second material and the fourth material are same.

5. The method according to any of the preceding claims, wherein a plurality of first holes and a plurality of second holes are generated such that each of the second holes at least partially overlaps with or adjoins at least one of the first holes and/or the second material.

6. The method according to any of the preceding claims, wherein the second material comprises a high thermally conductive material, and/or
wherein the second material has a thermal expansion coefficient substantially similar to a thermal expansion coefficient of a printed circuit board, and/or
wherein the second material comprises a high galvanic conductivity material, and/or
wherein the second material comprises a high heat dissipation material.

7. The method according to any of the preceding claims, wherein the carrier material comprises at least one inlaid portion of pressed-in copper embedded within the carrier material.

8. The method according to any of the preceding claims, wherein the carrier material comprises at least one inlaid portion of bonded or soldered copper embedded within the carrier material.

9. The method according to any of the preceding claims, wherein the carrier material comprises a printed circuit board.

10. A carrier material for use in an electric and/or thermal component, the carrier material comprising an electrically conductive portion and at least a first side portion adjacently arranged to the electrically conductive portion on a first side of the carrier material,
wherein multiple vias are provided in the first side portion, wherein each of the multiple vias comprises at least a first material, and
wherein each of the multiple vias at least partially overlaps or directly adjoins another of the multiple vias.

11. The carrier material according to claim 10, wherein each of the vias at least partially comprises a second material, wherein the second material is arranged between the first material and a body portion of the carrier material.

12. The carrier material according to any of claims 10 to 11, wherein the first material comprises a high thermally conductive material, and/or
wherein the first material has a thermal expansion coefficient substantially similar to a thermal expansion coefficient of a printed circuit board, and/or
wherein the first material comprises a high galvanic conductivity material, and/or
wherein the first material comprises a high heat dissipation material.

13. The carrier material according to any of claims 10 to 12, wherein the carrier material comprises a printed circuit board.

14. The carrier material according to any of claims 10 to 13, wherein the carrier material comprises at least one inlaid portion of pressed-in copper embedded within the carrier material, and/or
wherein the carrier material comprises at least one inlaid portion of bonded or soldered copper embedded within the carrier material.

15. The carrier material according to any of claims 10 to 14, wherein the conducting portion is configured for transmitting high frequency signals.
